# EUROPEAN PATENT APPLICATION

(11) **EP 4 604 181 A1**
(43) Date of publication of application: **20.08.2025**
(21) Application number: 23913920.7
(22) Date of filing: 03.01.2023
(51) Int. Cl.: H01L 31/04

(54) **PEROVSKITE CELL, PREPARATION METHOD THEREFOR, AND ELECTRICAL APPARATUS**

(71) Applicant: Contemporary Amperex Technology (Hong Kong) Limited, Central (HK)
(72) Inventor: SU, Shuojian, Ningde, Fujian 352100 (CN); LIN, Xiangling, Ningde, Fujian 352100 (CN); LI, Hanfang, Ningde, Fujian 352100 (CN); ZHANG, Fan, Ningde, Fujian 352100 (CN); CHEN, Guodong, Ningde, Fujian 352100 (CN); GUO, Yongsheng, Ningde, Fujian 352100 (CN)
(74) Representative: Gong, Jinping
(86) International application number: PCT/CN2023/070151
(87) International publication number: WO 2024/145758

(57) **Abstract**

This application provides a perovskite cell, a preparation method therefor, and an electric apparatus, and pertains to the field of solar cell technologies. The perovskite cell includes: a plurality of cell units arranged in a first direction, the cell unit including a first electrode layer, a second electrode layer, and a first perovskite layer located between the first electrode layer and the second electrode layer, that are arranged in a second direction; and a connection structure, the connection structure being configured to connect a first electrode layer of a first cell unit and a second electrode layer of a second cell unit that are adjacent among the plurality of cell units; where a conductive oxide layer is provided between the connection structure and the first perovskite layer. The technical solution of this application is conducive to improving the performance of the perovskite cell.

## Description

### TECHNICAL FIELD

This application relates to the field of solar cell technologies, and in particular, to a perovskite cell, a preparation method therefor, and an electric apparatus.

### BACKGROUND

In recent years, global energy shortage and environmental pollution problems are becoming more and more prominent, and solar cells are receiving more and more attention as an ideal renewable energy source. Solar cells, also referred to as photovoltaic cells, are apparatuses that convert light energy directly into electrical energy by photoelectric effects or photochemical effects. Perovskite cells are a widely researched new type of solar cell, which have rapidly achieved high photoelectric conversion efficiency in the years after its birth and have good application prospects.

However, the perovskite layer in the perovskite cell is unstable and is prone to reacting with some metals, which is not conducive to improving the performance of the perovskite cell. Therefore, how the performance of the perovskite cell is improved is an urgent technical problem to be solved.

### SUMMARY

This application has been made in view of the foregoing issues. An objective of this application is to provide a perovskite cell, a preparation method therefor, and an electric apparatus, so as to improve the performance of the perovskite cell.

According to a first aspect, this application provides a perovskite cell, including: a plurality of cell units arranged in a first direction, the cell unit including a first electrode layer, a second electrode layer, and a first perovskite layer located between the first electrode layer and the second electrode layer, that are arranged in a second direction; and a connection structure, the connection structure being configured to connect a first electrode layer of a first cell unit and a second electrode layer of a second cell unit that are adjacent among the plurality of cell units; where a conductive oxide layer is provided between the connection structure and the first perovskite layer.

An embodiment of this application provides a perovskite cell, including a plurality of cell units arranged in a first direction and a connection structure. The cell unit includes a first electrode layer, a second electrode layer, and a first perovskite layer located between the first electrode layer and the second electrode layer, that are arranged in a second direction, such that the cell unit can output power through the first electrode layer and the second electrode layer, and absorb sunlight through the first perovskite layer. The connection structure is configured to connect a first electrode layer of a first cell unit and a second electrode layer of a second cell unit that are adjacent among the plurality of cell units, thereby implementing the electrical connection between the adjacent first cell unit and second cell unit. A conductive oxide layer is provided between the connection structure and the first perovskite layer. The conductive oxide layer does not react with the connection structure. With the provision of the conductive oxide layer, the first perovskite layer does not directly contact the connection structure, reducing the risk of corrosion of the connection structure caused by reactions between the first perovskite layer and the connection structure. In addition, the risk of degradation at the position of the first perovskite layer corresponding to the connection structure can be reduced, which is conducive to improving the lifespan of the perovskite cell. Therefore, this embodiment of this application can improve the performance of the perovskite cell.

In a possible implementation, the conductive oxide layer extends from a first surface of the second electrode layer to a first surface of the first electrode layer, where the first surface of the second electrode layer is a surface of the second electrode layer close to the first electrode layer, and the first surface of the first electrode layer is a surface of the first electrode layer close to the second electrode layer. This facilitates the preparation of the conductive oxide layer by local deposition or adhesion, which is conducive to reducing the complexity of the production process.

In a possible implementation, the conductive oxide layer is provided between the connection structure and the first electrode layer. In this way, the conductive oxide layer can be prepared by deposition before the connection structure is prepared, which is conducive to reducing the complexity of the production process.

In a possible implementation, the connection structure is a conductive wall extending from the first surface of the second electrode layer to the first electrode layer, where the first surface of the second electrode layer is a surface of the second electrode layer close to the first electrode layer. This facilitates the preparation of the connection structure and is conducive to reducing the complexity of the production process.

In a possible implementation, the cell unit includes the first electrode layer, a first charge transport layer, the first perovskite layer, a second charge transport layer, and the second electrode layer sequentially disposed on a substrate. In this way, the transport of carriers in the perovskite cell can be implemented through the first charge transport layer and the second charge transport layer.

In a possible implementation, the conductive oxide layer is provided between the second electrode layer and the second charge transport layer. In this way, the conductive oxide layer can block the corrosion of the second electrode layer by halogen ions in the first perovskite layer to some extent and also play a role in blocking the diffusion of halogen ions to some extent, which is thus conducive to improving the efficiency of the perovskite cell.

In a possible implementation, the cell unit further includes a light absorption layer located between the first electrode layer and the second electrode layer. In this way, in the perovskite cell, in addition to the first perovskite layer, other light absorption layers are also provided, which is conducive to further improving the efficiency of the perovskite cell.

In a possible implementation, the light absorption layer includes a second perovskite layer, the cell unit further includes a third electrode layer, a third charge transport layer, the second perovskite layer, and a fourth charge transport layer sequentially disposed between the second charge transport layer and the second electrode layer, and the conductive oxide layer is provided between the connection structure and the second perovskite layer. In this implementation, the perovskite cell has higher efficiency, and the provision of the conductive oxide layer can extend the lifespan of the perovskite cell.

In a possible implementation, a band gap of the first perovskite layer is greater than that of the second perovskite layer. This is conducive to improving the absorption efficiency of sunlight, which is thus conducive to improving the photoelectric conversion efficiency.

In a possible implementation, the light absorption layer includes a copper indium gallium selenide layer, and the cell unit further includes a fifth charge transport layer, the copper indium gallium selenide layer, a sixth charge transport layer, and a fourth electrode layer sequentially disposed between the first electrode layer and the second charge transport layer. In this way, in a perovskite cell including other types of light absorption layers, the provision of the conductive oxide layer can extend the lifespan of the perovskite cell.

In a possible implementation, the second electrode layer and the connection structure are formed as an integral structure. In this way, the preparation of the second electrode layer and the connection structure can be completed in a single process step, which is conducive to reducing production costs.

In a possible implementation, a resistivity of the conductive oxide layer is less than 1*10⁻² Ω·cm; and optionally, the resistivity of the conductive oxide layer is less than 5*10⁻³ Ω·cm. In this way, an increase in internal resistance of the perovskite cell caused by a low conductivity or a high resistivity of the conductive oxide can be reduced, which is thus conducive to improving the efficiency of the perovskite cell and reducing the power loss of the perovskite cell.

In a possible implementation, a thickness of the conductive oxide layer is 5 nm to 100 nm, optionally 20 nm to 50 nm. In this way, the protective effect of the conductive oxide layer on the first perovskite layer, the second electrode layer, and the connection structure, as well as the efficiency and production costs of the perovskite cell can be taken into account.

In a possible implementation, a material of the conductive oxide layer includes at least one of indium tin oxide, indium zinc oxide, tungsten-doped indium oxide, gallium-doped zinc oxide, zinc aluminium oxide, lanthanum series metal doped indium oxide, indium hafnium oxide, indium tantalum oxide, or indium niobium oxide. In this way, the conductive oxide layer is a transparent structure, and the perovskite cell is a semi-transparent structure, which is conducive to discovering structural faults in the perovskite cell in a timely manner. In addition, the conductive oxide layer prepared from the foregoing materials is conducive to reducing the resistance of the perovskite cell, which is conducive to reducing the power loss of the perovskite cell.

In a possible implementation, a material of the first electrode layer is a transparent conductive oxide. This facilitates the passage of sunlight through the first electrode layer. In addition, both the first electrode layer and the conductive oxide layer are conductive oxides, and the contact resistance between the first electrode layer and the conductive oxide layer is small, which is conducive to reducing the power loss of the perovskite cell.

In a possible implementation, a material of the first electrode layer includes at least one of indium tin oxide, indium zinc oxide, tungsten-doped indium oxide, gallium-doped zinc oxide, zinc aluminium oxide, or fluorine-doped tin oxide. This ensures that the first electrode layer has good light transmittance and conductivity.

In a possible implementation, a material of the second electrode layer includes at least one of Au, Ag, Cu, Al, Ni, Cr, Bi, Pt, Mg, Mo, W, their alloys, or carbon materials; and optionally, the carbon material includes at least one of carbon black, graphene, or carbon nanotubes. This ensures that the second electrode layer has good conductivity.

In a possible implementation, a thickness of the first electrode layer is 300 nm to 800 nm, a thickness of the second electrode layer is 10 nm to 200 nm, and a thickness of the first perovskite layer is 300 nm to 800 nm; and optionally, the thickness of the first electrode layer is 400 nm to 600 nm, the thickness of the second electrode layer is 80 nm to 120 nm, and the thickness of the first perovskite layer is 400 nm to 600 nm. In this way, both the efficiency and energy density of the perovskite cell can be taken into account.

In a possible implementation, a structural formula of the first perovskite layer is ABX₃, where an ionic radius of A is 0.076 nm to 0.315 nm, an ionic radius of B is 0.06 nm to 0.15 nm, and an ionic radius of X is 0.1 nm to 0.2 nm; optionally, A includes at least one of an organic amine cation, Cs, K, Rb, or Li, B includes at least one of lead, tin, zinc, titanium, antimony, bismuth, nickel, iron, cobalt, silver, copper, gallium, germanium, magnesium, calcium, indium, aluminium, manganese, chromium, molybdenum, or europium, and X includes at least one of fluorine, chlorine, bromine, or iodine; and optionally, the organic amine cation includes at least one of a methylammonium cation or a formamidinium cation. In this way, the efficiency of perovskite cells can be ensured.

In a possible implementation, the first charge transport layer is a hole transport layer, and the second charge transport layer is an electron transport layer; or, the first charge transport layer is an electron transport layer, and the second charge transport layer is a hole transport layer. This facilitates flexible setting of the first charge transport layer and the second charge transport layer according to actual needs.

In a possible implementation, a material of the hole transport layer includes a P-type semiconductor, and a material of the electron transport layer includes an N-type semiconductor; optionally, the material of the hole transport layer includes at least one of thiophene, phthalocyanine, porphyrin, 2,2',7,7'-tetrakis(N,N-di-p-methoxyphenylamine)-9,9'-spirobifluorene, molybdenum oxide, vanadium oxide, tungsten oxide, nickel oxide, copper oxide, tin oxide, molybdenum sulfide, tungsten sulfide, copper sulfide, tin sulfide, copper thiocyanate, copper iodide, fluoro group-containing phosphonic acids, carbonyl group-containing phosphonic acids, carbon nanotubes, or graphene; and optionally, the material of the electron transport layer includes at least one of [6,6]-phenyl-C61-butyric acid methyl ester, C60, cyano group-containing polyphenylenevinylene, boron-containing polymers, bathocuproine, bathophenanthroline, hydroxyquinolinatoaluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, lithium fluoride, sodium fluoride, magnesium fluoride, or zinc sulfide. This facilitates flexible selection of the materials of the first charge transport layer and the second charge transport layer according to actual needs.

In a possible implementation, a thickness of the first charge transport layer is 10 nm to 200 nm, and a thickness of the second charge transport layer is 10 nm to 200 nm. In this way, it is conducive to ensuring the efficiency of the perovskite cell.

In a possible implementation, a material of the substrate includes at least one of glass or transparent flexible polymers; and optionally, the transparent flexible polymers include at least one of polyethylene terephthalate or polyimide. This facilitates flexible selection of the material of the substrate according to actual needs.

According to a second aspect, this application provides an electric apparatus, including the perovskite cell according to the first aspect and any possible implementations thereof, where the perovskite cell is configured to supply power to the electric apparatus.

According to a third aspect, this application provides a method for preparing a perovskite cell, including: providing a plurality of cell units arranged in a first direction, the cell unit including a first electrode layer, a second electrode layer, and a first perovskite layer located between the first electrode layer and the second electrode layer, that are arranged in a second direction; and providing a connection structure, the connection structure being configured to connect a first electrode layer of a first cell unit and a second electrode layer of a second cell unit that are adjacent among the plurality of cell units; where a conductive oxide layer is provided between the connection structure and the first perovskite layer. Perovskite cells prepared using this method have a longer lifespan.

In a possible implementation, the providing a plurality of cell units arranged in a first direction includes: providing a substrate, where the first electrode layer is provided on the substrate; sequentially depositing a first charge transport layer, a first perovskite layer, and a second charge transport layer on the first electrode layer; and depositing the second electrode layer on the second charge transport layer; and the providing a connection structure includes: etching the second charge transport layer in the second direction to expose the first electrode layer, forming a first notch groove; and depositing the conductive oxide layer on the second charge transport layer and in the first notch groove. With this method, the preparation of the conductive oxide layer can be achieved through a single deposition, which is conducive to reducing the complexity of the process.

An embodiment of this application provides a perovskite cell, including a plurality of cell units arranged in a first direction and a connection structure. The cell unit includes a first electrode layer, a second electrode layer, and a first perovskite layer located between the first electrode layer and the second electrode layer, that are arranged in a second direction, such that the cell unit can output power through the first electrode layer and the second electrode layer, and absorb sunlight through the first perovskite layer. The connection structure is configured to connect a first electrode layer of a first cell unit and a second electrode layer of a second cell unit that are adjacent among the plurality of cell units, thereby implementing the electrical connection between the adjacent first cell unit and second cell unit. A conductive oxide layer is provided between the connection structure and the first perovskite layer. The conductive oxide layer does not react with the connection structure. With the provision of the conductive oxide layer, the first perovskite layer does not directly contact the connection structure, reducing the risk of corrosion of the connection structure caused by reactions between the first perovskite layer and the connection structure. In addition, the risk of degradation at the position of the first perovskite layer corresponding to the connection structure can be reduced, which is conducive to improving the lifespan of the perovskite cell. Therefore, this embodiment of this application can improve the performance of the perovskite cell such as lifespan.

### BRIEF DESCRIPTION OF DRAWINGS

FIG. 1 is a schematic diagram of a perovskite cell according to an embodiment of this application;
FIG. 2 is a schematic diagram of a perovskite cell according to an embodiment of this application;
FIG. 3 is a schematic diagram of a perovskite cell according to an embodiment of this application;
FIG. 4 is a schematic diagram of a perovskite cell according to an embodiment of this application;
FIG. 5 is a schematic diagram of a perovskite cell according to an embodiment of this application;
FIG. 6 is a schematic diagram of a perovskite cell according to an embodiment of this application;
FIG. 7 is a schematic diagram of a perovskite cell according to an embodiment of this application;
FIG. 8 is a schematic diagram of a cell unit of a perovskite cell according to an embodiment of this application;
FIG. 9 is a schematic diagram of an electric apparatus according to an embodiment of this application; and
FIG. 10 is a schematic diagram of a method for preparing a perovskite cell according to an embodiment of this application.

### DESCRIPTION OF EMBODIMENTS

Hereinafter, embodiments of the perovskite cell, the electric apparatus, and the method for preparing the perovskite cell of this application will be specifically disclosed in detail with appropriate reference to the accompanying drawings. However, there may be cases in which unnecessary detailed descriptions are omitted. For example, detailed descriptions of well-known matters and repeated descriptions of actually identical structures have been omitted. This is to avoid unnecessarily prolonging the following description, for ease of understanding by persons skilled in the art. In addition, the accompanying drawings and the following descriptions are provided for persons skilled in the art to fully understand this application and are not intended to limit the subject matter recorded in the claims.

"Ranges" disclosed in this application are defined in the form of lower and upper limits. A given range is defined by one lower limit and one upper limit selected, where the selected lower and upper limits define boundaries of that special range. Ranges defined in this way may or may not include end values, and any combination may be used, meaning that any lower limit may be combined with any upper limit to form a range. For example, if ranges of 60-120 and 80-110 are provided for a specific parameter, it is understood that ranges of 60-110 and 80-120 can also be envisioned. In addition, if minimum values of a range are given as 1 and 2, and maximum values of the range are given as 3, 4, and 5, the following ranges can all be envisioned: 1-3, 1-4, 1-5, 2-3, 2-4, and 2-5. In this application, unless otherwise stated, a value range of "a-b" is a short representation of any combination of real numbers between a and b, where both a and b are real numbers. For example, a value range of "0-5" means that all real numbers in the range of "0-5" are listed herein, and "0-5" is just a short representation of a combination of these values. In addition, a parameter expressed as an integer greater than or equal to 2 is equivalent to disclosure that the parameter is, for example, an integer among 2, 3, 4, 5, 6, 7, 8, 9, 10, 11, 12, and so on.

Unless otherwise specified, all the embodiments and optional embodiments of this application can be combined with each other to form new technical solutions.

Unless otherwise stated, all the technical features and optional technical features of this application can be combined with each other to form new technical solutions.

Unless otherwise specified, all the steps in this application can be performed sequentially or randomly, and preferably, are performed sequentially. For example, the method including steps (a) and (b) indicates that the method may include steps (a) and (b) performed sequentially or may include steps (b) and (a) performed sequentially. For example, the foregoing method may further include step (c), which indicates that step (c) may be added to the method in any ordinal position, for example, the method may include steps (a), (b), and (c), steps (a), (c), and (b), steps (c), (a), and (b), or the like.

Unless otherwise specified, "include" and "contain" mentioned in this application are inclusive or may be exclusive. For example, the terms "include" and "contain" can mean that other unlisted components may also be included or contained, or only listed components are included or contained.

Unless otherwise stated, in this application, the term "or" is inclusive. For example, the phrase "A or B" means "A, B, or both A and B". More specifically, any one of the following conditions satisfies the condition "A or B": A is true (or present) and B is false (or not present); A is false (or not present) and B is true (or present); or both A and B are true (or present).

Solar cells, also referred to as photovoltaic cells, are apparatuses that convert light energy directly into electrical energy by photoelectric effects or photochemical effects. Perovskite cells are a widely researched new type of solar cell, which have rapidly achieved high photoelectric conversion efficiency in the years after its birth and have good application prospects. A perovskite cell includes a plurality of cell units and a connection structure, where the connection structure implements electrical connection between adjacent cell units by connecting a first electrode layer and a second electrode layer of adjacent cell units.

The applicants have found through research that the connection structure is usually made of metal material, and reactions occur when the metal connection structure comes into contact with a perovskite layer in the perovskite cell, which may cause problems such as corrosion of the connection structure and degradation of the perovskite, all of which are not conducive to improving the performance of the perovskite cell.

In view of this, this application provides a perovskite cell. In the perovskite cell, a conductive oxide layer is provided between the perovskite layer and the connection structure, which is conducive to reducing the risk of corrosion of the connection structure and decomposition of the perovskite layer and thereby is conducive to improving the performance of the perovskite cell.

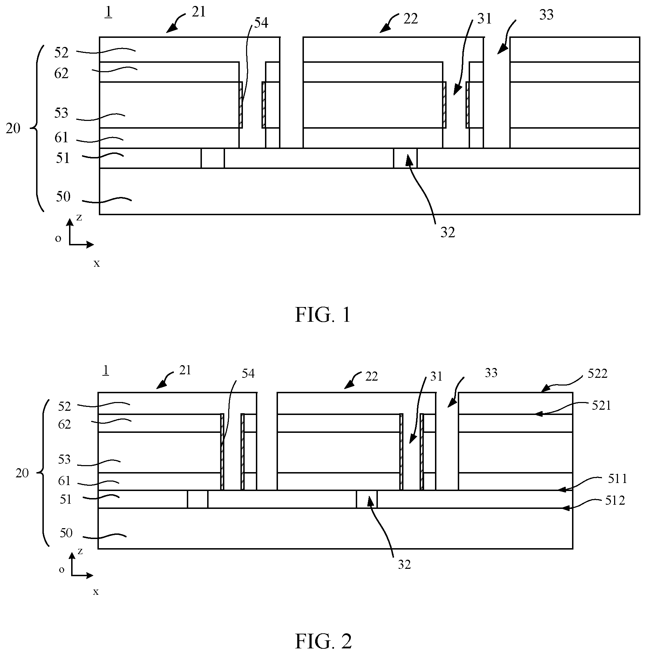

FIG. 1 is a schematic diagram of a perovskite cell according to an embodiment of this application. As shown in FIG. 1, a perovskite cell 1 includes a plurality of cell units 20 arranged in a first direction and a connection structure 31.

The first direction is an arrangement direction of the plurality of cell units 20, for example, direction x in FIG. 1.

The cell unit 20 includes a first electrode layer 51, a second electrode layer 52, and a first perovskite layer 53 located between the first electrode layer 51 and the second electrode layer 52, that are arranged in a second direction. Optionally, the second direction, for example, direction z in FIG. 1, is perpendicular to the first direction.

The first electrode layer 51 and the second electrode layer 52 are configured to output the power of the perovskite cell 1. The materials of the first electrode layer 51 and the second electrode layer 52 can be set according to actual needs, as long as the power output of the perovskite cell 1 can be achieved.

The first perovskite layer 53 is a light absorption layer. The first perovskite layer 53 can generate electron-hole pairs when exposed to sunlight.

The connection structure 31 is configured to connect a first electrode layer 51 of a first cell unit 21 and a second electrode layer 52 of a second cell unit 22 that are adjacent among the plurality of cell units 20. In other words, the plurality of cell units 20 include the first cell unit 21 and the second cell unit 22 that are adjacent, and the first electrode layer 51 of the first cell unit 21 and the second electrode layer 52 of the second cell unit 22 are connected through the connection structure 31. The connection structure 31 is a conductive structure. The connection structure 31 implements series connection of adjacent cell units 20.

Optionally, the connection structure 31 and the second electrode layer 52 are made of a same material. For example, both the connection structure 31 and the second electrode layer 52 are made of a metal material.

A conductive oxide layer 54 is provided between the connection structure 31 and the first perovskite layer 53.

The conductive oxide layer 54 is conductive and does not react with the connection structure 31 and the first perovskite layer 53.

The connection structure 31 has two surfaces opposite to each other in the first direction. For example, a region of one of the two surfaces opposite to the first perovskite layer 53 is provided with a conductive oxide layer 54. For another example, as shown in FIG. 1, regions of the two surfaces opposite to the first perovskite layer 53 are each provided with a conductive oxide layer 54.

It should be noted that whether the conductive oxide layer 54 is provided on two surfaces or one of the two surfaces of the connection structure 31 opposite in the first direction can be set according to a specific structure of the perovskite cell 1 and actual needs, for example, set according to the specific structure of the connection structure 31 or a spacing between the connection structure 31 and another structure.

Optionally, the conductive oxide layer 54 is attached between the first perovskite layer 53 and the connection structure 31 by adhesion. Optionally, the conductive oxide layer 54 is provided between the first perovskite layer 53 and the connection structure 31 by local deposition or other methods.

An embodiment of this application provides a perovskite cell 1, including a plurality of cell units 20 arranged in a first direction and a connection structure 31. The cell unit 20 includes a first electrode layer 51, a second electrode layer 52, and a first perovskite layer 53 located between the first electrode layer 51 and the second electrode layer 52, that are arranged in a second direction, such that the cell unit 20 can output power through the first electrode layer 51 and the second electrode layer 52, and absorb sunlight through the first perovskite layer 53. The connection structure 31 is configured to connect a first electrode layer 51 of a first cell unit 21 and a second electrode layer 52 of a second cell unit 22 that are adjacent among the plurality of cell units 20, thereby implementing the electrical connection between the adjacent first cell unit 21 and second cell unit 22. A conductive oxide layer 54 is provided between the connection structure 31 and the first perovskite layer 53. The conductive oxide layer 54 does not react with the connection structure 31. With the provision of the conductive oxide layer 54, the first perovskite layer 53 does not directly contact the connection structure 31, reducing the risk of corrosion of the connection structure 31 caused by reactions between the first perovskite layer 53 and the connection structure 31. In addition, the risk of degradation at the position of the first perovskite layer 53 corresponding to the connection structure 31 can be reduced, which is conducive to improving the lifespan of the perovskite cell 1. Therefore, this embodiment of this application can improve the performance of the perovskite cell 1.

FIG. 2 is a schematic diagram of a perovskite cell according to an embodiment of this application. In some embodiments, as shown in FIG. 2, a conductive oxide layer 54 extends from a first surface 521 of a second electrode layer 52 to a first surface 511 of a first electrode layer 51.

The second electrode layer 52 includes two surfaces opposite to each other in the second direction, that is, thickness direction of the second electrode layer 52. The first surface 521 of the second electrode layer 52 is a surface of the second electrode layer 52 close to the first electrode layer 51.

The first electrode layer 51 includes two surfaces opposite to each other in the second direction, that is, thickness direction of the first electrode layer 51. The first surface 511 of the first electrode layer 51 is a surface of the first electrode layer 51 close to the second electrode layer 52.

In this embodiment, the conductive oxide layer 54 can be prepared by deposition or adhesion before a connection structure 31 is prepared, so that the conductive oxide layer 54 is provided between the first perovskite layer 53 and the connection structure 31, which is conducive to reducing the complexity of the production process.

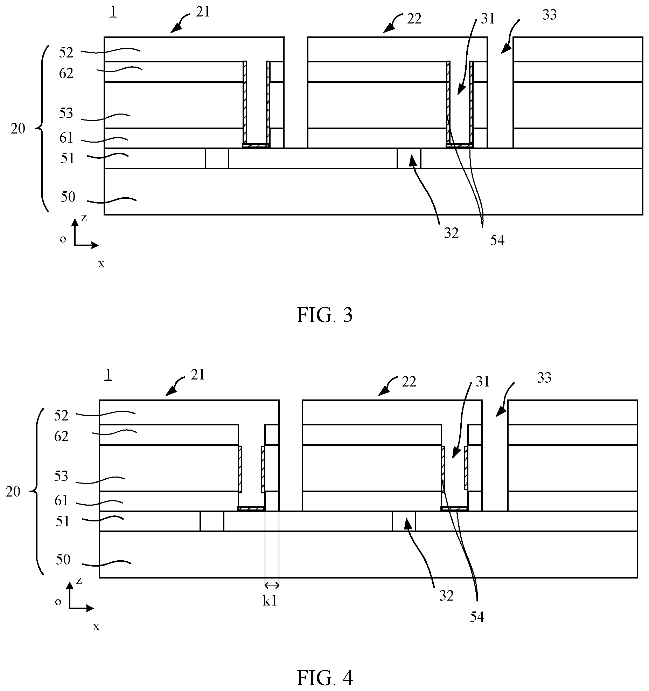

FIG. 3 is a schematic diagram of a perovskite cell according to an embodiment of this application. In some embodiments, as shown in FIG. 3, a conductive oxide layer 54 is provided between a connection structure 31 and a first electrode layer 51.

Optionally, in this embodiment, before a second electrode layer 52 and the connection structure 31 are fabricated, a cell unit 20 can be etched in a second direction to form a notch groove. Afterwards, a conductive oxide is deposited on the inner surface of the notch groove to form a conductive oxide layer 54.

In this embodiment, the conductive oxide layer can be prepared by deposition before the connection structure 31 is prepared, which is conducive to reducing the complexity of the production process.

FIG. 4 is a schematic diagram of a perovskite cell according to an embodiment of this application. As shown in FIG. 4, a conductive oxide layer 54 is provided between a first perovskite layer 53 and a region of a connection structure 31 corresponding to the first perovskite layer 53; and a conductive oxide layer 54 is provided between the connection structure 31 and a first electrode layer 51. Optionally, the conductive oxide layer 54 can be prepared by adhesion or local coating.

In some embodiments, as shown in FIG. 1 to FIG. 4, the connection structure 31 is a conductive wall extending from a first surface 521 of a second electrode layer 52 to the first electrode layer 51, where the first surface 521 of the second electrode layer 52 is a surface of the second electrode layer 52 close to the first electrode layer 51.

A conductive wall means that the connection structure 31 is a conductive columnar structure with a thickness, optionally a rectangular columnar structure.

For example, the connection structure 31 may be a conductive wall formed by filling a recess extending from the first surface 521 of the second electrode layer 52 to the first electrode layer 51. The connection structure 31 is made of a same material as that of the second electrode layer 52. In other words, the connection structure 32 and the second electrode layer 52 are formed through a single deposition step.

Optionally, the connection structure 31 extends from the first surface 521 of the second electrode layer 52 to the first surface 511 of the first electrode layer 51 in the second direction.

Optionally, the connection structure 31 extends from the first surface 521 of the second electrode layer 52 to a second surface 512 of the first electrode layer 51 in the second direction, where the second surface 512 of the first electrode layer 51 is a surface of the first electrode layer 51 away from the second electrode layer 52.

In this embodiment, the connection structure 31 is provided as a conductive wall extending from the first surface 521 of the second electrode layer 52 to the first electrode layer 51 in the second direction, which facilitates the preparation of the connection structure 31 and reduces the complexity of the production process.

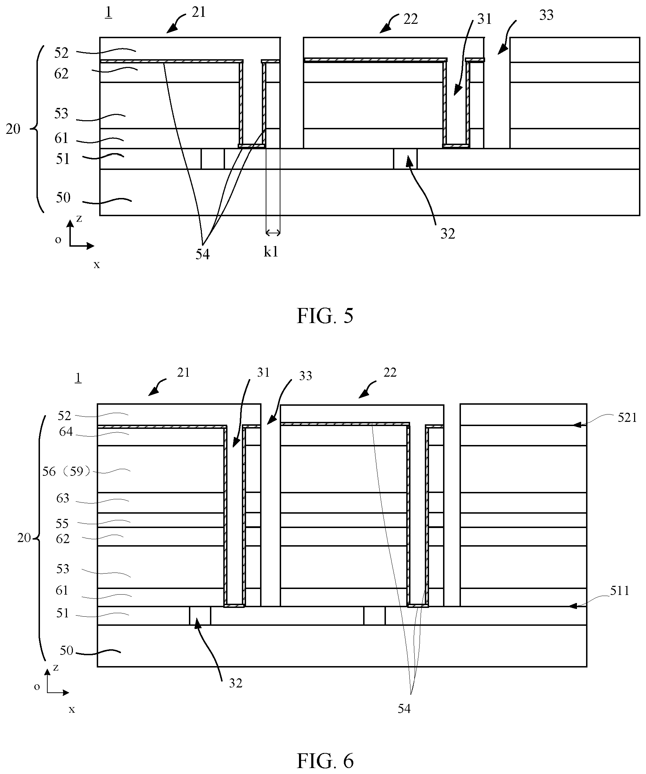

FIG. 5 is a schematic diagram of a perovskite cell according to an embodiment of this application. In some embodiments, as shown in FIG. 1 to FIG. 5, the cell unit 20 includes the first electrode layer 51, a first charge transport layer 61, the first perovskite layer 53, a second charge transport layer 62, and the second electrode layer 52 sequentially disposed on a substrate 50.

For example, as shown in FIG. 1, the conductive oxide layer 54 is only provided between the first perovskite layer 53 and the connection structure 31. For another example, as shown in FIG. 2, FIG. 3, and FIG. 5, a conductive oxide layer 54 may also be provided between the first charge transport layer 61 and the connection structure 31 and between the second charge transport layer 62 and the connection structure 31. For another example, as shown in FIG. 4, a conductive oxide layer 54 may not be provided between the first charge transport layer 61 and the connection structure 31 and between the second charge transport layer 62 and the connection structure 31.

The first charge transport layer 61 and the second charge transport layer 62 are used to transport carriers, for example, electrons or holes.

In this embodiment, the transport of carriers in the perovskite cell 1 can be implemented through the provision of the first charge transport layer 61 and the second charge transport layer 62.

In some embodiments, as shown in FIG. 5, a conductive oxide layer 54 is provided between the second electrode layer 52 and the second charge transport layer 62.

In this embodiment, the conductive oxide layer 54 provided between the second electrode layer 52 and the second charge transport layer 62 can block the corrosion of the second electrode layer 52 by halogen ions in the first perovskite layer 53 to some extent and also play a role in blocking the diffusion of halogen ions to some extent. In addition, the conductive oxide layer 54 can also reduce leakage current and carrier recombination caused by the contact between the first perovskite layer 53 and the second electrode layer 52. Therefore, this embodiment is conducive to improving the efficiency of the perovskite cell 1.

Optionally, the perovskite cell 1 further includes a first isolation structure 32 and a second isolation structure 33.

The first isolation structure 32 is configured to isolate a first electrode layer 51 of an adjacent first cell unit 21 from a first electrode layer 51 of an adjacent second cell unit 22. The size of the first isolation structure 32 in the second direction and the shape of the first isolation structure 32 are not specifically limited in the embodiments of this application, as long as the isolation of the first electrode layers 51 of adjacent cell units 20 can be achieved.

For example, the first isolation structure 32 is a notch groove running through the first electrode layer 51. In other words, the first isolation structure 32 extends from the first surface 511 of the first electrode layer 51 to the second surface 512 of the first electrode layer 51 in the second direction. For another example, the first isolation structure 32 runs through the first electrode layer 51 and the substrate 50 in the second direction. For another example, the first isolation structure 32 runs through the first charge transport layer 61 and the first electrode layer 51 in the second direction. For another example, the first isolation structure 32 is an insulating wall extending from the first surface 511 of the first electrode layer 51 to the second surface 512 of the first electrode layer 51 in the second direction, and the insulating wall is formed from an insulating material.

The second isolation structure 33 is configured to isolate a second electrode layer 52 of an adjacent first cell unit 21 from a second electrode layer 51 of an adjacent second cell unit 22. The size of the second isolation structure 33 in the second direction and the shape of the second isolation structure 33 are not specifically limited in the embodiments of this application, as long as the isolation of the second electrode layers 52 of adjacent cell units 20 can be achieved.

For example, the second isolation structure 33 is a notch groove running from the second surface 522 of the second electrode layer 52 to the first surface 511 of the first electrode layer 51 in the second direction, where the second surface 522 of the second electrode layer 52 is a surface of the second electrode layer 52 away from the first electrode layer 51. For another example, the second isolation structure 33 is an insulating wall running from the second surface 522 of the second electrode layer 52 to the first surface 511 of the first electrode layer 51 in the second direction, and the insulating wall is formed from an insulating material.

Optionally, in the first direction, the connection structure 31 is spaced apart from the first isolation structure 32.

Optionally, in the first direction, the connection structure 31 is spaced apart from the second isolation structure 33. For example, as shown in FIG. 4 and FIG. 5, a distance k1 between the connection structure 31 and the second isolation structure 33 is 5 µm to 25 µm. This is conducive to the fabrication of the second isolation structure 33, facilitates the reduction of the difficulty of process preparation, and, in addition, helps to reduce the waste of materials between the connection structure 31 and the second isolation structure 33.

The distance k1 between the connection structure 31 and the second isolation structure 33 is the minimum distance between the two, and this distance can be measured by an optical microscope.

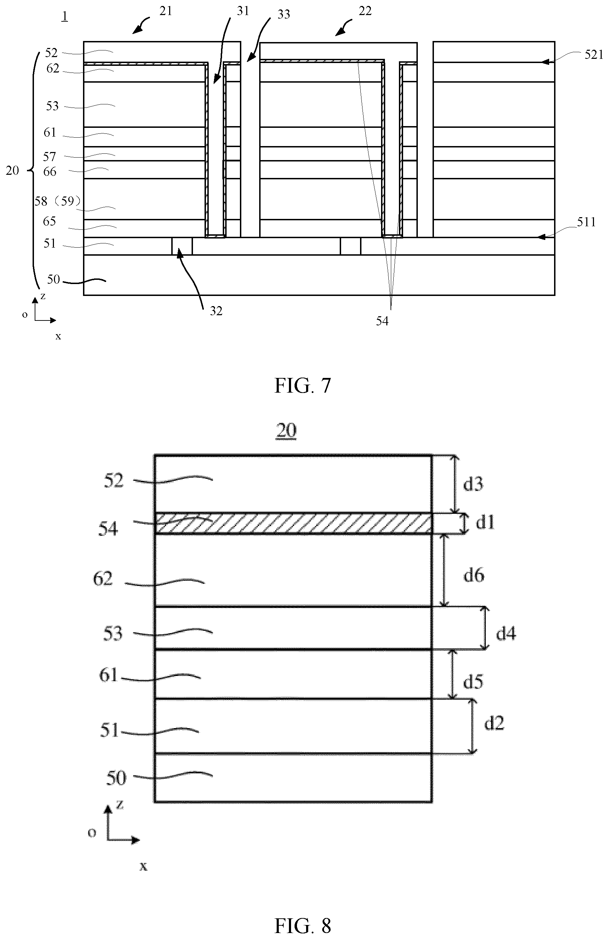

FIG. 6 is a schematic diagram of a perovskite cell according to an embodiment of this application; and FIG. 7 is a schematic diagram of a perovskite cell according to an embodiment of this application. In some embodiments, as shown in FIG. 6 and FIG. 7, the cell unit 20 further includes a light absorption layer 59 located between the first electrode layer 51 and the second electrode layer 52.

In other words, in the perovskite cell 1, the first perovskite layer 53 and the light absorption layer 59 other than the first perovskite layer 53 are included. This is conducive to improving the efficiency of the perovskite cell 1.

In some embodiments, as shown in FIG. 6, the light absorption layer 59 includes a second perovskite layer 56, the cell unit 20 further includes a third electrode layer 55, a third charge transport layer 63, the second perovskite layer 56, and a fourth charge transport layer 64 sequentially disposed between the second charge transport layer 62 and the second electrode layer 52, and a conductive oxide layer 54 is provided between the connection structure 31 and the second perovskite layers 56.

The cell unit 20 shown in FIG. 6 can refer to a cell unit 20 with a laminated structure. The cell unit 20 shown in FIG. 6 includes two sub-cells, one of which includes a structure of electrode layer-charge transport layer-perovskite layer-charge transport layer-electrode layer. Optionally, the cell unit 20 may alternatively include more than two sub-cells, for example, three, four, or more.

Optionally, as shown in FIG. 6, the conductive oxide layer 54 extends from a first surface 521 of a second electrode layer 52 to a first surface 511 of a first electrode layer 51; the conductive oxide layer 54 is provided between the connection structure 31 and the first electrode layer 51; and the conductive oxide layer 54 is provided between the second electrode layer 52 and the fourth charge transport layer 64.

Optionally, in the first direction, only a region of the second perovskite layer 56 opposite to the connection structure 31 and a region of the first perovskite layer 53 opposite to the connection structure 31 are provided with the conductive oxide layer 54.

Optionally, the conductive oxide layer 54 extends from the first surface 521 of the second electrode layer 52 to the first surface 511 of the first electrode layer 51 in the second direction; the conductive oxide layer 54 is provided between the connection structure 31 and the first electrode layer 51 in the second direction; and no conductive oxide layer 54 is provided between the second electrode layer 52 and the fourth charge transport layer 64 in the second direction.

Optionally, for a specific structure of the conductive oxide layer 54 not specifically mentioned in the perovskite cell 1 with a laminated structure, reference may be made to the specific structure of the conductive oxide layer 54 in the perovskite cell 1 of a non-laminated structure in FIG. 1 to FIG. 5. Details are not repeated herein.

In this embodiment, the perovskite cell 1 has a laminated structure and, therefore, can have higher efficiency. In addition, the provision of the conductive oxide layer 54 can improve the lifespan of the perovskite cell 1.

In some embodiments, a band gap of the first perovskite layer 53 is greater than that of the second perovskite layer 56. This is conducive to improving the absorption efficiency of sunlight, which is thus conducive to improving the photoelectric conversion efficiency.

Optionally, the band gap of the first perovskite layer 53 is 1.7 eV to 1.9 eV, and the band gap of the second perovskite layer 56 is 0.8 eV to 1.2 eV.

The band gap can be measured by an ultraviolet-visible absorption spectrometer.

Optionally, the material of the first perovskite layer 53 is Cs_{0.35}FA_{0.65}PbI_{1.8}Br_{1.2}; and the material of the second perovskite layer 56 is FA_{0.7}MA_{0.3}Pb_{0.5}Sn_{0.5}I₃.

In some embodiments, as shown in FIG. 7, the light absorption layer 59 includes a copper indium gallium selenide layer 58, and the cell unit 20 further includes a fifth charge transport layer 65, the copper indium gallium selenide layer 58, a sixth charge transport layer 66, and a fourth electrode layer 57 sequentially disposed between the first electrode layer 51 and the second charge transport layer 62.

The perovskite cell 1 shown in FIG. 7 includes two light absorption layers, namely the copper indium gallium selenide layer 58 and the first perovskite layer 53. The perovskite cell 1 has a laminated structure and has high efficiency.

This embodiment provides a perovskite cell 1 including another type of light absorption layer, and the cell has a laminated structure and can have higher efficiency. In addition, the provision of the conductive oxide layer 54 can improve the lifespan of the perovskite cell 1.

In some embodiments, the second electrode layer 52 and the connection structure 31 are formed as an integral structure. In other words, the second electrode layer 52 and the connection structure 31 are formed in a single process step. In this way, the preparation of the second electrode layer 52 and the connection structure 31 can be completed in a single process step, which is conducive to reducing production costs.

Optionally, the connection structure 31 and the second electrode layer 52 are formed through a single deposition step.

In some embodiments, a resistivity of the conductive oxide layer 54 is less than 1*10⁻² Ω·cm. For example, the resistivity of the conductive oxide layer is 10⁻³ Ω·cm or 10⁻⁴ Ω·cm.

The resistivity of the conductive oxide layer 54 is the same as or close to the resistivity of the material of the conductive oxide layer 54, and can be measured by a resistivity tester.

In this embodiment, the resistivity of the conductive oxide layer 54 is less than 1*10⁻² Ω·cm. This is conducive to reducing the risk of an increase in internal resistance of the perovskite cell 1 caused by the corrosion of the second electrode layer 52, and, in addition, can reduce an increase in internal resistance of the perovskite cell 1 caused by a low conductivity or a high resistivity of the conductive oxide 54, which is thus conducive to reducing the power loss of the perovskite cell 1. Therefore, this embodiment is conducive to improving the efficiency of the perovskite cell 1.

Optionally, the resistivity of the conductive oxide layer 54 is less than 5*10⁻³ Ω·cm. This is conducive to further improving the efficiency of the perovskite cell 1.

FIG. 8 is a schematic diagram of a cell unit of a perovskite cell according to an embodiment of this application. In some embodiments, as shown in FIG. 8, thickness d1 of the conductive oxide layer 54 is 5 nm to 100 nm, optionally 20 nm to 50 nm. For example, the thickness d1 of the conductive oxide layer 54 may be 5 nm, 10 nm, 15 nm, 20 nm, 25 nm, 35 nm, 45 nm, 50 nm.

Optionally, the conductive oxide layer 54 is a uniform thin layer with approximately the same thickness at different positions. For ease of identification in this embodiment, only the thickness of the conductive oxide layer 54 between the second charge transport layer 62 and the second electrode layer 52 is shown, and this range also applies to the thickness of the conductive oxide layer 54 at other positions.

Optionally, the thickness of the conductive oxide layer 54 is different at different positions. For example, the thickness of the conductive oxide layer 54 between the connection structure 31 and the first perovskite layer 53 is different from the thickness of the conductive oxide layer 54 between the second electrode layer 52 and the second charge transport layer 62. For example, the thickness of the later is less than the thickness of the former.

The thickness d1 of the conductive oxide layer 54 may be the maximum thickness of the conductive oxide layer 54.

The thickness d1 of the conductive oxide layer 54 may be measured by a step profiler.

When the thickness d1 of the conductive oxide layer 54 is less than 5 nm, the protective effect on the first perovskite layer 53, the connection structure 31, and the second electrode layer 52 is weak, and the improvement in the stability and lifespan of the perovskite cell 1 is small; and the thickness d1 of the conductive oxide layer 54 is too small, which is not conducive to reducing the complexity of the preparation process.

When the thickness d1 of the conductive oxide layer 54 is greater than 100 nm, its excessive thickness leads to an increase in the resistance of the perovskite cell 1, which is not conducive to reducing the power loss of the perovskite cell 1 and improving the efficiency of the perovskite cell 1; and excessive thickness also leads to an increase in production costs.

In this embodiment, the thickness d1 of the conductive oxide layer 54 is 5 nm to 100 nm. In this way, the protective effect of the conductive oxide layer 54 on the first perovskite layer 53, the connection structure 31, and the second electrode layer 52, as well as the efficiency and production costs of the perovskite cell 1 can be taken into account.

When the thickness d1 of the conductive oxide layer 54 is 20 nm to 50 nm, both the efficiency and lifespan of the perovskite cell 1 can be better taken into account, for example, the perovskite cell 1 has higher efficiency or longer lifespan.

Optionally, the material of the conductive oxide layer 54 is a transparent conductive oxide. In this way, the conductive oxide layer 54 is a transparent structure, and the perovskite cell 1 is a semi-transparent structure, which is conducive to discovering structural faults in the perovskite cell 1 in a timely manner.

In some embodiments, the material of the conductive oxide layer 54 includes at least one of indium tin oxide (Indium Tin Oxide, ITO), indium zinc oxide (Indium Zinc Oxide, IZO), tungsten-doped indium oxide (Tungsten-doped Indium Oxide, IWO), gallium-doped zinc oxide (Gallium-doped Zinc Oxide, GZO), zinc aluminium oxide (Zinc Aluminium Oxide, AZO), lanthanum series metal doped indium oxide, indium hafnium oxide, indium tantalum oxide, or indium niobium oxide.

Lanthanum series metal doped indium oxide may include cerium-doped indium oxide, that is, ICO.

In this embodiment, the conductive oxide layer 54 prepared from the foregoing materials is a transparent structure, and the perovskite cell 1 is a semi-transparent structure, which is conducive to discovering structural faults in the perovskite cell 1 in a timely manner. In addition, the conductive oxide layer 54 prepared from the above materials is conducive to reducing the resistance of the perovskite cell 1 and is conducive to reducing the power loss of the perovskite cell 1.

In some embodiments, a material of the first electrode layer 51 is a transparent conductive oxide. This facilitates the passage of sunlight through the first electrode layer 51. In addition, both the first electrode layer 51 and the conductive oxide layer 54 are conductive oxides, and the contact resistance between the first electrode layer 51 and the conductive oxide layer 54 is small, which is conducive to reducing the power loss of the perovskite cell 1.

In some embodiments, the material of the first electrode layer 51 includes at least one of indium tin oxide, indium zinc oxide, tungsten-doped indium oxide, gallium-doped zinc oxide, zinc aluminium oxide, or fluorine-doped tin oxide. This ensures that the first electrode layer 51 has good light transmittance and conductivity.

In some embodiments, the material of the second electrode layer 52 includes Au, Ag, Cu, Al, Ni, Cr, Bi, Pt, Mg, Mo, W, their alloys, or carbon materials; and optionally, the carbon material includes at least one of carbon black, graphene, or carbon nanotubes. This ensures that the second electrode layer has good conductivity.

Optionally, the material of the second electrode layer 52 may further include indium tin oxide, indium zinc oxide, tungsten-doped indium oxide, gallium-doped zinc oxide, zinc aluminium oxide, or lanthanum series metal doped indium oxide.

In some embodiments, thickness d2 of the first electrode layer 51 is 300 nm to 800 nm, thickness d3 of the second electrode layer 52 is 10 nm to 200 nm, and thickness d4 of the first perovskite layer 53 is 300 nm to 800 nm.

The thickness d2 of the first electrode layer 51, the thickness d3 of the second electrode layer 52, and the thickness d4 of the first perovskite layer 53 can respectively be the maximum thickness of the first electrode layer 51, the second electrode layer 52, and the first perovskite layer 53; and their thickness can be measured by a step profiler.

When the thickness d2 of the first electrode layer 51 is greater than 800 nm, the transmittance of the first electrode layer decreases, which is not conducive to improving the efficiency of the perovskite cell 1. When the thickness d2 of the first electrode layer 51 is less than 300 nm, the conductivity of the first electrode layer is low, making it difficult to ensure the lifespan and efficiency of the perovskite cell 1.

When the thickness d3 of the second electrode layer 52 is greater than 200 nm, the perovskite cell 1 occupies a larger space, which is not conducive to improving the energy density of the perovskite cell 1. When the thickness d3 of the second electrode layer 52 is less than 10 nm, it is difficult to ensure the lifespan and efficiency of the perovskite cell 1.

When the thickness d4 of the first perovskite layer 53 is greater than 800 nm, the perovskite cell 1 occupies a larger space, which is not conducive to improving the energy density of the perovskite cell 1. When the thickness d4 of the first perovskite layer 53 is less than 300 nm, the first perovskite layer 53 is thin and cannot fully absorb incident light, which is not conducive to improving the efficiency of the cell.

In the embodiments, with reasonable setting of the thickness d2 of the first electrode layer 51, the thickness d3 of the second electrode layer 52, and the thickness d4 of the first perovskite layer 53, both the efficiency and the energy density of the perovskite cell 1 can be taken into account.

Optionally, the thickness d2 of the first electrode layer 51 is 400 nm to 600 nm, the thickness d3 of the second electrode layer 52 is 80 nm to 120 nm, and the thickness d4 of the first perovskite layer 53 is 400 nm to 600 nm. This is conducive to further improving the efficiency and energy density of the perovskite cell 1.

In some embodiments, a structural formula of the first perovskite layer 53 is ABX₃, where an ionic radius of A is 0.076 nm to 0.315 nm, an ionic radius of B is 0.06 nm to 0.15 nm, and an ionic radius of X is 0.1 nm to 0.2 nm; optionally, A includes at least one of an organic amine cation, Cs, K, Rb, or Li, B includes at least one of lead, tin, zinc, titanium, antimony, bismuth, nickel, iron, cobalt, silver, copper, gallium, germanium, magnesium, calcium, indium, aluminium, manganese, chromium, molybdenum, or europium, and X includes at least one of fluorine, chlorine, bromine, or iodine; and optionally, the organic amine cation includes at least one of a methylammonium cation or a formamidinium cation.

The first perovskite layer 53 is prepared from perovskite. In other words, the structural formula of the first perovskite layer 53 is a structural formula of the perovskite from which the first perovskite layer 53 is prepared.

Optionally, the material of the first perovskite layer 53 is three-dimensional perovskite. For example, when A is an organic amine cation, the organic amine cation is selected from at least one of a methylammonium cation or a formamidinium cation.

In the embodiments, with the selection of the perovskite with the foregoing structural formula as the material of the first perovskite layer 53, the efficiency of the perovskite cell 1 can be ensured.

In some embodiments, the first charge transport layer 61 is a hole transport layer, and the second charge transport layer 62 is an electron transport layer; or, the first charge transport layer 61 is an electron transport layer, and the second charge transport layer 62 is a hole transport layer. This facilitates flexible setting of the first charge transport layer and the second charge transport layer according to actual needs.

The cell unit 20 may be a normal structure system or an inverted structure system.

For example, as shown in FIG. 6 and FIG. 7, when the cell unit 20 is a normal structure system, the first charge transport layer 61 is a hole transport layer, the second charge transport layer 62 is an electron transport layer, the third charge transport layer 63 is a hole transport layer, and the fourth charge transport layer 64 is an electron transport layer. When the cell unit 20 is an inverted structure system, the first charge transport layer 61 is an electron transport layer, the second charge transport layer 62 is a hole transport layer, the third charge transport layer 63 is an electron transport layer, and the fourth charge transport layer 64 is a hole transport layer.

In some embodiments, a material of the hole transport layer includes a P-type semiconductor, and a material of the electron transport layer includes an N-type semiconductor; optionally, the material of the hole transport layer includes at least one of thiophene, phthalocyanine, porphyrin, 2,2',7,7'-tetrakis(N,N-di-p-methoxyphenylamine)-9,9'-spirobifluorene (Spiro-OMeTAD), molybdenum oxide, vanadium oxide, tungsten oxide, nickel oxide, copper oxide, tin oxide, molybdenum sulfide, tungsten sulfide, copper sulfide, tin sulfide, copper thiocyanate, copper iodide, fluoro group-containing phosphonic acids, carbonyl group-containing phosphonic acids, carbon nanotubes, or graphene; and optionally, the material of the electron transport layer includes at least one of [6,6]-phenyl-C61-butyric acid methyl ester, C60, cyano group-containing polyphenylenevinylene, boron-containing polymers, bathocuproine, bathophenanthroline, hydroxyquinolinatoaluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, lithium fluoride, sodium fluoride, magnesium fluoride, or zinc sulfide. This facilitates flexible selection of the materials of the first charge transport layer 61 and the second charge transport layer 62 according to actual needs.

In some embodiments, thickness d5 of the first charge transport layer 61 is 10 nm to 200 nm, and thickness d6 of the second charge transport layer 62 is 10 nm to 200 nm. In this way, the efficiency of perovskite cells can be ensured.

The thickness d5 of the first charge transport layer 61 or the thickness d6 of the second charge transport layer 62 may be, for example, 10 nm, 15 nm, 20 nm, 25 nm, 30 nm, 50 nm, 60 nm, 80 nm, 100 nm, 120 nm, 150 nm, 180 nm, or 200 nm.

When the thickness d5 of the first charge transport layer 61 or the thickness d6 of the second charge transport layer 62 is greater than 200 nm, the perovskite cell 1 occupies a larger space, which is not conducive to improving the energy density.

When the thickness d5 of the first charge transport layer 61 or the thickness d6 of the second charge transport layer 62 is less than 10 nm, it is not conducive to ensuring the performance of the first charge transport layer 61 or the second charge transport layer 62.

Optionally, when the material of the first charge transport layer 61 is nickel oxide, the thickness of the first charge transport layer 61 does not exceed 50 nm, for example, 10 nm to 50 nm. When the first charge transport layer 61 is prepared from other materials, its thickness can reach 200 nm. For example, the material of the first charge transport layer 61 is Spiro-OMeTAD.

In some embodiments, a material of the substrate 50 includes at least one of glass or transparent flexible polymers; and optionally, the transparent flexible polymers include at least one of polyethylene terephthalate or polyimide. This facilitates flexible selection of the material of the substrate according to actual needs, for example, whether to prepare a rollable perovskite cell.

This application provides an electric apparatus, including the perovskite cell 1 according to any of the foregoing embodiments, where the perovskite cell 1 is configured to supply power to the electric apparatus.

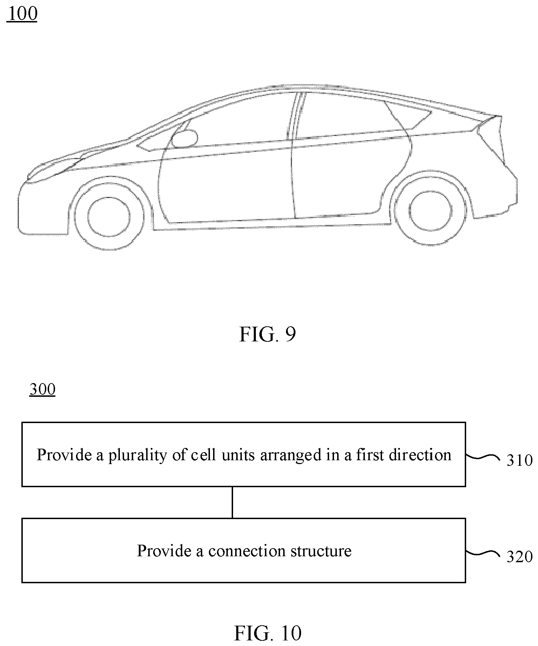

FIG. 9 is a schematic diagram of an electric apparatus according to an embodiment of this application. As shown in FIG. 9, the electric apparatus is a vehicle 100, and the perovskite cells 1 are provided on the vehicle 100 and used to supply power to the vehicle 100 or an accumulator in the vehicle 100.

Optionally, the electric apparatus may alternatively be other devices such as a street light and a power storage station.

The foregoing has described in detail the product embodiments of the perovskite cell 1 of this application with reference to FIG. 1 to FIG. 9, and the following describes in detail an embodiment of a method for preparing the perovskite cell of this application. It should be understood that the method embodiment corresponds to the product embodiments, and similar descriptions may refer to the product embodiments.

FIG. 10 is a schematic diagram of a method for preparing a perovskite cell according to an embodiment of this application. As shown in FIG. 10, this application provides a method 300 for preparing a perovskite cell, including step 310 and step 320.

Step 310: Provide a plurality of cell units 20 arranged in a first direction.

The cell unit 20 includes a first electrode layer 51, a second electrode layer 52, and a first perovskite layer 53 located between the first electrode layer 51 and the second electrode layer 52, that are arranged in a second direction.

Step 320: Provide a connection structure 31.

The connection structure 31 is configured to connect a first electrode layer 51 of a first cell unit 21 and a second electrode layer 52 of a second cell unit 22 that are adjacent among the plurality of cell units 20, where a conductive oxide layer 54 is provided between the connection structure 31 and the first perovskite layer 51.

In this embodiment of this application, the perovskite cell 1 prepared using the method 300 has high efficiency and lifespan.

In some embodiments, step 310 includes: providing a substrate 50, where the first electrode layer 51 is provided on the substrate 50; sequentially depositing a first charge transport layer 61, a first perovskite layer 53 and a second charge transport layer 62 on the first electrode layer 51; and depositing the second electrode layer 52 on the second charge transport layer 62.

Step 320 includes: etching the second charge transport layer 62 in the second direction to expose the first electrode layer 51, forming a first notch groove; and depositing the conductive oxide layer 54 on the second charge transport layer 62 and in the first notch groove.

With this method, the preparation of the conductive oxide layer 54 can be achieved through a single deposition, which is conducive to reducing the complexity of the process.

Optionally, in some embodiments, after the second charge transport layer 62 is etched in the second direction to expose the first electrode layer 51, forming the first notch groove, the conductive oxide layer 54 is deposited in the first notch groove; and after the conductive oxide layer 54 is deposited, corresponding materials are deposited in the first notch groove and on the second charge transport layer 62 to form the connection structure 31 and the second electrode layer 52.

Optionally, after step 320, the method 300 further includes providing a second isolation structure 33. Specifically, after the second electrode layer 52 is prepared, the second electrode layer 52 is etched in the second direction to expose the first electrode layer 51, forming a second notch groove. The second notch groove may serve as the second isolation structure 33.

Optionally, before preparing the first charge transport layer 61, the method 300 further includes etching the first electrode layer 51 in the second direction to expose the substrate 50, forming a third notch groove. The third notch groove can serve as the first isolation structure 32.

### Example

The following describes examples of this application. The examples described below are illustrative and only used to explain this application, and cannot be construed as limitations on this application. Examples whose technical solutions or conditions are not specified are made in accordance with technical solutions or conditions described in literature in the field, or made in accordance with product instructions. The reagents or instruments used are all conventional products that are commercially available if no manufacturer is indicated.

### Example 1

The structure of Example 1 can be seen in FIG. 1, and a method for preparing a perovskite cell 1 shown in Example 1 is as follows.
(1) Taking a piece of 100 mm*100 mm fluorine-doped tin oxide (Fluorine-doped Tin Oxide, FTO) conductive glass, where the FTO conductive glass serves as a substrate 50 provided with a first electrode layer 51.
(2) After cleaning, using a nanosecond infrared laser to scribe the FTO conductive glass to form a P1 notch groove running through the first conductive layer 51, preparing a first isolation structure 32.
(3) Using a magnetron sputtering method to prepare a 20 nm thick layer of nickel oxide on the FTO conductive glass, forming a first charge transport layer 61.
(4) Applying a 1 mol/L MAPbI₃ precursor solution to the first charge transport layer 61, then transferring the conductive glass to a vacuum device to vacuumize for 60 s at a vacuum degree of 15Pa; and after vacuumizing, placing the conductive glass with the first charge transport layer 61 on a hot plate, annealing the conductive glass at 100°C for 15 minutes to obtain a MAPbI₃ perovskite layer with a thickness of about 500 nm, forming a first perovskite layer 53.
(5) On the first perovskite layer 53, using an evaporation method to deposit 25 nm of C60, 6 nm of BCP, and 20 nm of Cu, forming a second charge transport layer 62, where C60 and BCP serve as the second charge transport layer 62, and Cu serves to protect the second charge transport layer 62 during the preparation of a second electrode layer 52.
(6) Using a picosecond green laser to scribe the conductive glass prepared with the second charge transport layer 62, forming a P2 notch groove running in the second direction from a surface of the second charge transport layer 62 away from the first electrode layer 51 to a surface of the first electrode layer 51 close to the second electrode layer 52.
(7) Using a mask template with a slot to cover the component, with a region exposed in the P2 notch groove corresponding to the first perovskite layer 53, and preparing a 5 nm ITO layer using a PVD method, preparing a conductive oxide layer 54.
(8) Using an evaporation method to deposit 100 nm of Cu in the P2 notch groove and on the surface of the second charge transport layer 62, preparing a connection structure 31 and the second electrode layer 52.
(9) Using the picosecond green laser to scribe the second electrode layer 52, exposing a surface of the first electrode layer 51 close to the second electrode layer 52, forming a P3 notch groove. The P3 notch groove serves as a second isolation structure 33.

### Example 2

The structure of Example 2 can be seen in FIG. 2, and this example differs from Example 1 in that the conductive oxide layer 54 extends from the first surface 521 of the second electrode layer 52 to the first surface 511 of the first electrode layer 51 in the second direction.

### Example 3

The structure of Example 3 can be seen in FIG. 3, and this example differs from Example 2 in that the conductive oxide layer 54 is provided between the connection structure 31 and the first electrode layer 51 in the second direction.

### Example 4

The structure of Example 4 can be seen in FIG. 5, and this example differs from Example 3 in that the conductive oxide layer is provided between the second electrode layer 52 and the second charge transport layer 62 in the second direction.

### Example 5

The structure of Example 5 can be seen in FIG. 6, and this example differs from Example 4 in that the perovskite cell 1 is a laminated cell structure. In Example 5, the substrate 50 is a glass substrate, the first electrode layer 51 is ITO, the first charge transport layer 61 is NiO, the first perovskite layer 53 is Cs_{0.35}FA_{0.65}PbI_{1.8}Br_{1.2}, the second charge transport layer 62 is C60 and SnO₂, the third electrode layer 55 is Au, the third charge transport layer 63 is PEDOT:PSS, the second perovskite layer 56 is FA_{0.7}MA_{0.3}Pb_{0.5}Sn_{0.5}I₃, the material of the fourth charge transport layer 64 is C60 and SnO₂, and the second electrode layer 52 is Ag.

### Example 6

The structure of Example 6 can be seen in FIG. 7, and the perovskite cell 1 is a laminated cell structure. In Example 6, the substrate 50 is a glass substrate, the first conductive layer 51 is Mo, the fifth charge transport layer 65 is PTAA, the light absorption layer 58 is CIGS, the sixth charge transport layer 66 is ZnO, the fourth electrode layer 57 is indium tin oxide, the first charge transport layer 61 is PTAA, the first perovskite layer 53 is Cs_{0.09}FA_{0.77}MA_{0.14}Pb(I_{0.86},Br_{0.14})₃, the second charge transport layer 62 is PCBM, and the second electrode layer 52 is indium tin oxide.

### Examples 7 to 18

Examples 7 to 18 differ from Example 4 in that the thickness of the ITO layer, that is, the conductive oxide layer 54, is 10 nm, 20 nm, 30 nm, 40 nm, 50 nm, 60 nm, 70 nm, 80 nm, 90 nm, 100 nm, 2 nm, and 150 nm, respectively.

### Examples 19 to 23

Examples 19 to 23 differ from Example 8 in that the conductive oxide layer 54 is IZO layer, GZO layer, IWO layer, ITO layer, AZO layer, and ICO layer, respectively.

### Example 24

Comparative example 24 differs from Example 4 in that the conductive oxide layer 54 is zinc oxide, and the resistivity of zinc oxide is greater than 10⁻² Ω·cm.

In Examples 1 to 24, the thickness of the first electrode layer 51 is 500 nm, the thickness of the second electrode layer 52 is 100 nm, the thickness of the first perovskite layer 53 is 500 nm, the thickness of the first charge transport layer 61 is 20 nm, and the thickness of the second charge transport layer 62 is 51 nm.

### Examples 25 to 30

Examples 25 to 30 differ from Example 8 in the thickness of the first electrode layer 51, the thickness of the second electrode layer 52, the thickness of the first charge transport layer 61, and the thickness of the second charge transport layer 62.

### Comparative example 1

Comparative Example 1 differs from Example 1 in that in the perovskite cell 1, no conductive oxide layer 54 is provided between the first perovskite layer 53 and the connection structure 31.

The resistivity of the conductive oxide layer 54 can be measured by a resistivity tester.

The perovskite cells prepared in the above examples and comparative examples were tested for efficiency and lifespan.

### Method for testing cell efficiency

Under conditions of room temperature and less than 2% RH, the efficiency of the cells was tested under standard simulated sunlight (AM1.5G, 100 mW/cm²), and the efficiency value can be directly measured by a solar simulator.

### Method for testing cell lifespan

After 1000 hours of storage in the dark at 25°C and 50% to 60% RH, the efficiency of the cells was tested under standard simulated sunlight (AM1.5G, 100 mW/cm²). Efficiency retention rate = efficiency after 1000 hours of storage / initial efficiency * 100%.

### Experimental results

Experimental results of different examples are shown in Tables 1 and 2.

As shown in Tables 1 and 2, d1 is the thickness of the conductive oxide layer 54, d2 is the thickness of the first electrode layer 51, d3 is the thickness of the second electrode layer 52, d4 is the thickness of the first perovskite layer 53, d5 is the thickness of the first charge transport layer 61, and d6 is the thickness of the second charge transport layer 62.

**Table 1 Experimental results of Examples 1 to 24 and Comparative example 1**

| | Conductive oxide layer | d1 (nm) | Resistivity (Ω·cm) | Cell efficiency (%) | Efficiency retention rate after 1000 h of storage (%) |
|---|---|---|---|---|---|
| Example 1 | ITO | 5 | 6.1*10⁻⁴ | 15 | 77 |
| Example 2 | ITO | 5 | 6.1*10⁻⁴ | 15 | 78 |
| Example 3 | ITO | 5 | 6.1*10⁻⁴ | 15 | 78 |
| Example 4 | ITO | 5 | 6.1*10⁻⁴ | 15 | 78 |
| Example 5 | ITO | 5 | 6.1*10⁻⁴ | 23 | 60 |
| Example 6 | ITO | 5 | 6.1*10⁻⁴ | 22 | 70 |
| Example 7 | ITO | 10 | 6.1*10⁻⁴ | 15.3 | 79 |
| Example 8 | ITO | 20 | 6.1*10⁻⁴ | 15.3 | 79 |
| Example 9 | ITO | 30 | 6.1*10⁻⁴ | 15.4 | 79 |
| Example 10 | ITO | 40 | 6.1*10⁻⁴ | 15.4 | 79 |
| Example 11 | ITO | 50 | 6.1*10⁻⁴ | 15.4 | 78 |
| Example 12 | ITO | 60 | 6.1*10⁻⁴ | 15 | 79 |
| Example 13 | ITO | 70 | 6.1*10⁻⁴ | 15.4 | 80 |
| Example 14 | ITO | 80 | 6.1*10⁻⁴ | 15.4 | 82 |
| Example 15 | ITO | 90 | 6.1*10⁻⁴ | 15.6 | 83 |
| Example 16 | ITO | 100 | 6.1*10⁻⁴ | 15.7 | 83 |
| Example 17 | ITO | 2 | 6.1*10⁻⁴ | 10 | 13 |
| Example 18 | ITO | 150 | 6.1*10⁻⁴ | 10.0 | 90 |
| Example 19 | IZO | 20 | 2.2*10⁻⁴ | 15 | 80 |
| Example 20 | GZO | 20 | 5.3*10⁻⁴ | 15 | 80 |
| Example 21 | IWO | 20 | 4.7*10⁴ | 15.4 | 79 |
| Example 22 | AZO | 20 | 3*10⁻⁴ | 15.1 | 80 |
| Example 23 | FTO | 20 | 4.8*10⁻³ | 14.9 | 80 |
| Example 24 | ZnO | 5 | >10⁻² | 6 | 90 |
| Comparative example 1 | / | / | / | 9 | 12 |

**Table 2 Experimental results of Example 8 and Examples 25 to 30**

| | d2 (nm) | d3 (nm) | d4 (nm) | d5 (nm) | d6 (nm) | Cell efficiency (%) | Efficiency retention rate after 1000 h of storage (%) |
|---|---|---|---|---|---|---|---|
| Example 8 | 500 | 100 | 500 | 20 | 31 | 14 | 78 |
| Example 25 | 300 | 10 | 300 | 10 | 20 | 12 | 79 |
| Example 26 | 300 | 50 | 300 | 50 | 10 | 13 | 77 |
| Example 27 | 400 | 80 | 400 | 50 | 10 | 14 | 79 |
| Example 28 | 500 | 100 | 500 | 25 | 35 | 12 | 80 |
| Example 29 | 600 | 120 | 600 | 25 | 35 | 13 | 80 |
| Example 30 | 800 | 200 | 800 | 30 | 50 | 12 | 79 |

As shown in Table 1, when the thickness of the conductive oxide layer is 5 nm to 100 nm, the perovskite cell has higher efficiency and lifespan. As shown in Comparative example 1, in the perovskite cell, when no conductive oxide layer is provided between the first perovskite layer and the connection structure, the perovskite cell has lower efficiency and lifespan. As shown in Example 17 and Comparative example 1, when the thickness of the conductive oxide layer is less than 5 nm, the lifespan of the perovskite cell is improved, but the improvement effect is weak. As shown in Example 18 and Comparative example 1, when the thickness of the conductive oxide layer is greater than 150 nm, although the perovskite cell has a longer lifespan, the efficiency improvement effect of the cell is weak. As shown in Example 24, when the resistivity of the conductive oxide layer is greater than 10⁻² Ω·cm, the efficiency of the cell is lower. As shown in Table 1, when the resistivity of the conductive oxide layer is less than 10⁻² Ω·cm and less than 5*10⁻³ Ω·cm, the efficiency of the perovskite cell is significantly improved.

As shown in Table 1, the conductive oxide layer can be made of various materials, such as ITO and IZO.

As shown in Tables 1 and 2, with reasonable setting of the thickness of the first electrode layer, the second electrode layer, the first perovskite layer, the first charge transport layer, and the second charge transport layer, better cell efficiency and lifespan can be achieved.

It should be noted that this application is not limited to the foregoing embodiments. The foregoing embodiments are merely examples, and embodiments having substantially the same constructions and the same effects as the technical idea within the scope of the technical solutions of this application are all included in the technical scope of this application. In addition, without departing from the essence of this application, various modifications made to the embodiments that can be conceived by persons skilled in the art, and other manners constructed by combining some of the constituent elements in the embodiments are also included in the scope of this application.

## Claims

1. A perovskite cell, **characterized by** comprising:
a plurality of cell units (20) arranged in a first direction, the cell unit (20) comprising a first electrode layer (51), a second electrode layer (52), and a first perovskite layer (53) located between the first electrode layer (51) and the second electrode layer (52), that are arranged in a second direction; and
a connection structure (31), the connection structure (31) being configured to connect a first electrode layer (51) of a first cell unit (21) and a second electrode layer (52) of a second cell unit (22) that are adjacent among the plurality of cell units (20);
wherein a conductive oxide layer (54) is provided between the connection structure (31) and the first perovskite layer (53).

2. The perovskite cell according to claim 1, **characterized in that** the conductive oxide layer (54) extends from a first surface (521) of the second electrode layer (52) to a first surface (511) of the first electrode layer (51), wherein the first surface (521) of the second electrode layer (52) is a surface of the second electrode layer (52) close to the first electrode layer (51), and the first surface (511) of the first electrode layer (51) is a surface of the first electrode layer (51) close to the second electrode layer (52).

3. The perovskite cell according to claim 1 or 2, **characterized in that** the conductive oxide layer (54) is provided between the connection structure (31) and the first electrode layer (51).

4. The perovskite cell according to any one of claims 1 to 3, **characterized in that** the connection structure (31) is a conductive wall extending from the first surface (521) of the second electrode layer (52) to the first electrode layer (51), wherein the first surface (521) of the second electrode layer (52) is a surface of the second electrode layer (52) close to the first electrode layer (51).

5. The perovskite cell according to any one of claims 1 to 4, **characterized in that** the cell unit (20) comprises the first electrode layer (51), a first charge transport layer (61), the first perovskite layer (53), a second charge transport layer (62), and the second electrode layer (52) sequentially disposed on a substrate (50).

6. The perovskite cell according to claim 5, **characterized in that** the conductive oxide layer (54) is provided between the second electrode layer (52) and the second charge transport layer (62).

7. The perovskite cell according to claim 5 or 6, **characterized in that** the cell unit (20) further comprises a light absorption layer (59) located between the first electrode layer (51) and the second electrode layer (52).

8. The perovskite cell according to claim 7, **characterized in that** the light absorption layer (59) comprises a second perovskite layer (56), the cell unit (20) further comprises a third electrode layer (55), a third charge transport layer (63), the second perovskite layer (56), and a fourth charge transport layer (64) sequentially disposed between the second charge transport layer (62) and the second electrode layer (52), and the conductive oxide layer (54) is provided between the connection structure (31) and the second perovskite layers (56).

9. The perovskite cell according to claim 8, **characterized in that** a band gap of the first perovskite layer (53) is greater than that of the second perovskite layer (56).

10. The perovskite cell according to claim 7, **characterized in that** the light absorption layer (59) comprises a copper indium gallium selenide layer (58), and the cell unit (20) further comprises a fifth charge transport layer (65), the indium gallium selenide layer (58), a sixth charge transport layer (66), and a fourth electrode layer (57) sequentially disposed between the first electrode layer (51) and the second charge transport layer (62).

11. The perovskite cell according to any one of claims 1 to 10, **characterized in that** the second electrode layer (52) and the connection structure (31) are formed as an integral structure.

12. The perovskite cell according to any one of claims 1 to 11, **characterized in that** a resistivity of the conductive oxide layer (54) is less than 1*10⁻² Ω·cm; and optionally, the resistivity of the conductive oxide layer (54) is less than 5*10⁻³ Ω·cm.

13. The perovskite cell according to any one of claims 1 to 12, **characterized in that** a thickness (d1) of the conductive oxide layer (54) is 5 nm to 100 nm, optionally 20 nm to 50 nm.

14. The perovskite cell according to any one of claims 1 to 13, **characterized in that** a material of the conductive oxide layer (54) comprises at least one of indium tin oxide, indium zinc oxide, tungsten-doped indium oxide, gallium-doped zinc oxide, zinc aluminium oxide, lanthanum series metal doped indium oxide, indium hafnium oxide, indium tantalum oxide, or indium niobium oxide.

15. The perovskite cell according to any one of claims 1 to 14, **characterized in that** a material of the first electrode layer (51) is a transparent conductive oxide.

16. The perovskite cell according to claim 15, **characterized in that** a material of the first electrode layer (51) comprises at least one of indium tin oxide, indium zinc oxide, tungsten-doped indium oxide, gallium-doped zinc oxide, zinc aluminium oxide, or fluorine-doped tin oxide.

17. The perovskite cell according to any one of claims 1 to 16, **characterized in that** a material of the second electrode layer (52) comprises at least one of Au, Ag, Cu, Al, Ni, Cr, Bi, Pt, Mg, Mo, W, their alloys, or carbon materials; and optionally, the carbon material comprises at least one of carbon black, graphene, or carbon nanotubes.

18. The perovskite cell according to any one of claims 1 to 17, **characterized in that** a thickness (d2) of the first electrode layer (51) is 300 nm to 800 nm, a thickness (d3) of the second electrode layer (52) is 10 nm to 200 nm, and a thickness (d4) of the first perovskite layer (53) is 300 nm to 800 nm; and optionally, the thickness (d2) of the first electrode layer (51) is 400 nm to 600 nm, the thickness (d3) of the second electrode layer (52) is 80 nm to 120 nm, and the thickness (d4) of the first perovskite layer (53) is 400 nm to 600 nm.

19. The perovskite cell according to any one of claims 1 to 18, **characterized in that** a structural formula of the first perovskite layer (53) is ABX₃, wherein
an ionic radius of A is 0.076 nm to 0.315 nm, an ionic radius of B is 0.06 nm to 0.15 nm, and an ionic radius of X is 0.1 nm to 0.2 nm;
optionally, A comprises at least one of an organic amine cation, Cs, K, Rb, or Li, B comprises at least one of lead, tin, zinc, titanium, antimony, bismuth, nickel, iron, cobalt, silver, copper, gallium, germanium, magnesium, calcium, indium, aluminium, manganese, chromium, molybdenum, or europium, and X comprises at least one of fluorine, chlorine, bromine, or iodine; and
optionally, the organic amine cation comprises at least one of a methylammonium cation or a formamidinium cation.

20. The perovskite cell according to any one of claims 5 to 19, **characterized in that** the first charge transport layer (61) is a hole transport layer, and the second charge transport layer (62) is an electron transport layer; or, the first charge transport layer (61) is an electron transport layer, and the second charge transport layer (62) is a hole transport layer.

21. The perovskite cell according to claims 20, **characterized in that** a material of the hole transport layer comprises a P-type semiconductor, and a material of the electron transport layer comprises an N-type semiconductor;
optionally, the material of the hole transport layer comprises at least one of thiophene, phthalocyanine, porphyrin, 2,2',7,7'-tetrakis(N,N-di-p-methoxyphenylamine)-9,9'-spirobifluorene, molybdenum oxide, vanadium oxide, tungsten oxide, nickel oxide, copper oxide, tin oxide, molybdenum sulfide, tungsten sulfide, copper sulfide, tin sulfide, copper thiocyanate, copper iodide, fluoro group-containing phosphonic acids, carbonyl group-containing phosphonic acids, carbon nanotubes, or graphene; and
optionally, the material of the electron transport layer comprises at least one of [6,6]-phenyl-C61-butyric acid methyl ester, C60, cyano group-containing polyphenylenevinylene, boron-containing polymers, bathocuproine, bathophenanthroline, hydroxyquinolinatoaluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, lithium fluoride, sodium fluoride, magnesium fluoride, or zinc sulfide.

22. The perovskite cell according to any one of claims 5 to 21, **characterized in that** a thickness (d5) of the first charge transport layer (61) is 10 nm to 200 nm, and a thickness (d6) of the second charge transport layer (62) is 10 nm to 200 nm.

23. The perovskite cell according to any one of claims 5 to 22, **characterized in that** a material of the substrate (50) comprises at least one of glass or transparent flexible polymers; and optionally, the transparent flexible polymers comprise at least one of polyethylene terephthalate or polyimide.

24. An electric apparatus, **characterized by** comprising the perovskite cell according to any one of claims 1 to 23, wherein the perovskite cell is configured to supply power to the electric apparatus.

25. A method for preparing a perovskite cell, **characterized by** comprising:
providing (310) a plurality of cell units (20) arranged in a first direction, the cell unit (20) comprising a first electrode layer (51), a second electrode layer (52), and a first perovskite layer (53) located between the first electrode layer (51) and the second electrode layer (52), that are arranged in a second direction; and
providing (320) a connection structure (31), the connection structure (31) being configured to connect a first electrode layer (51) of a first cell unit (21) and a second electrode layer (52) of a second cell unit (22) that are adjacent among the plurality of cell units (20); wherein a conductive oxide layer (54) is provided between the connection structure (31) and the first perovskite layer (53).

26. The method according to claim 25, **characterized in that** the providing (310) a plurality of cell units (20) arranged in a first direction comprises:
providing a substrate (50), wherein the first electrode layer (51) is provided on the substrate (50);
sequentially depositing a first charge transport layer (61), a first perovskite layer (53), and a second charge transport layer (62) on the first electrode layer (51); and
depositing the second electrode layer (52) on the second charge transport layer (62); and
the providing (320) a connection structure (31) comprises:
etching the second charge transport layer (62) in the second direction to expose the first electrode layer (51), forming a first notch groove; and
depositing the conductive oxide layer (54) on the second charge transport layer (62) and in the first notch groove.
